(19) Europäisches Patentamt
European Patent Office
Office européen des brevets

(11) Publication number: **0 419 200 A2**

# (12) EUROPEAN PATENT APPLICATION

(21) Application number: **90310180.6**

(22) Date of filing: **18.09.90**

(51) Int. Cl.[5]: **H01L 39/24**

(30) Priority: **18.09.89 JP 241573/89**
**29.01.90 JP 16212/90**

(43) Date of publication of application:
**27.03.91 Bulletin 91/13**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Ri, Seigen**
**5-302, Bamu Haitsu Kikuna, 1-30 Kaminomiya**
**Tsurumi-ku, Yokohama-shi, Kanagawa**
**230(JP)**

(74) Representative: **Silverman, Warren et al**
**HASELTINE LAKE & CO. Hazlitt House 28**
**Southampton Buildings Chancery Lane**
**London WC2A 1AT(GB)**

## (54) Method for producing oxide superconductors.

(57) A method for producing an oxide superconductor comprises the steps of forming on a substrate a layer of elements which is deficient in respect of one element for producing an oxide superconductor from said elements and immersing said substrate with layer formed thereon in a solution containing at leat one supplementary element required for producing said oxide superconductor.

EP 0 419 200 A2

# METHOD FOR PRODUCING OXIDE SUPERCONDUCTOR

This invention relates to a method for producing an oxide superconductor, for example an A-Ce-Cu-O type oxide superconductor (wherein A is a lanthanoid element or rare earth element) or a Bi oxide superconductor.

Recently attempts to apply a metal or alloy superconductor to a device have been made. Nevertheless, since the critical temperature, Tc, is low, such a device could not be used in liquid helium. On the other hand, a oxide superconductor has a high Tc and has the ability to be used in liquid nitrogen.

As the oxide superconductor a hole injection type oxide superconductor such as yttrium (Y) or bismuth (Bi) type and an electron injection type oxide superconductor such as $Ln_{2-X}Ce_XCuO_{4-Y}$ type are well known.

A hole injection type oxide superconductor needs to be annealed in an oxidizing atmosphere. On the other hand, an electron injection type oxide superconductor needs to be annealed in a reducing atmosphere.

It is noted that the oxide superconductor is applied to an interconnection or wiring layer in an electrical device.

To produce the electrical device a reducing atmosphere is often used. Thus, an electron injection type oxide superconductor which needs annealing in a reducing atmosphere is often used.

A conventional oxide superconductor is produced by a sputtering method usually using a sintered mass as a target.

For example, in the case of a $Ln_{2-X}Ce_XCu_{4-Y}$ type oxide superconductor, a sintered mass containing the elements Ln (lanthanide), Ce ( cerium), Cu (copper) etc., is produced and sputtering is effected using the sintered bulk as a target whereby the superconductor film is formed on a required substrate.

Since a conventional $Ln_{2-X}Ce_XCU_{4-Y}$ type oxide superconductor film is produced by a sputtering method, Ce is contained therein in such a manner that it is solid-dissolved in Ln. Therefore a uniform addition of Ce or control of the addition thereof is very difficult.

Furthermore, the film composition has readily varying phases such as $CeO_2$ , $Ln_2O_7$ , etc., other than superconducting $Ln_{2-X}Ce_XCuO_{4-Y}$ and the superconducting properties of the obtained superconductor are deteriorated as a result.

Further, in the case of a Bi type oxide superconductor such as $(Bi_{2-X-Y}Pb_XSb_Y)Sr_2Ca_2Cu_3O_{10}$, a sintered mass made of $Bi_2O_3$ , PbO, $Sb_2O_3$ , $SrCO_3$ , $CaCO_3$ and CuO is used as a target to carry out a sputtering method. In the case of $(Bi_{2-X-Y}Pb_XSb_Y)Sr_2Ca_2Cu_3O_{10}$, Sb is present in such a manner that it is solid dissolved in Bi. Addition of a required or constant amount of Sb is very difficult because the additional amount of Sb is small and Sb is easily aggregated. Thus, a reproducible superconductor composition cannot be obtained and $Sb_2O_3$ or an unidentified phase other than a $(Bi_{2-X-Y}Pb_XSb_Y)Sr_2Ca_2Cu_3O_{10}$ phase was found.

It is an object of the present invention to provide a method for producing a superconductor having a stable uniform composition.

According to this invention, there is provided a method for producing an oxide superconductor comprising the steps of:

forming on a substrate a layer of (n-m) elements wherein n represents the number of elements which is to form an oxide superconductor and m is an integer less than n such that m ≧ 1; and

immersing the substrate with said layer thereon in a solution containing a supplementary element which is a said oxide superconductor composing element not present in said layer.

In one embodiment of the present invention, the layer is of A-Cu-O type (wherein A is lanthanoid element or a rare earth element) compound. Preferably A is a lanthanoid element selected from Ln, Nd, Sm, Pr and Y.

In the present invention, when Ce is used as a non-skeletal supplementary element, a Ce-containing solution is preferably selected from cerium nitrate $Ce(NO_3)_3$, cerium acetate $Ce(CH_3COO)_3$, cerium carbonate $Ce_2(CO_3)_3$ and cerium oxalate $Ce_2(C_2O_4)_3$ solutions.

In a second aspect, this invention provides a method for producing an oxide superconductor comprising the steps of:

forming a layer of oxide superconductor-forming elements on a substrate and

immersing said substrate with said layer formed thereon in a solution containing a supplementary element which is at least one of elements composing said oxide superconductor.

According to an alternative embodiment of the present invention the layer consists of $(Bi_{2-X}Pb_X)Sr_2Ca_2Cu_3O_{10}$. When Sb is used as a supplementary element, an Sb-containing solution is preferably selected from, antimonyl chloride (SbOCl), antimony trichloride $SbCl_3$ and chloroantimonic acid ($H_3SbCl_6$).

According to the present invention, by saturating a layer of main oxide superconductor composing elements with a supplementary element by immersing the layer in a solution containing the supplementary element, the supplementary element is uniformly added to the layer so that an oxide superconductor can be obtained. Thus, the occurrence of another phase which is not a superconductor phase is prevented.

Further, according to the present invention, by controlling the concentration and temperature of the supplementary solution and by controlling the supplementary element-saturation time, the added amount of the supplementary element can be easily controlled.

In the description which follows hereinafter, reference will be made to the accompanying drawings, wherein:

Figure 1 is a flow chart showing a method of producing a superconductor according to the present invention.

Figure 2 is a schematic view showing a sputtering device for use in the method of the present invention.

Figures 3 and 4 are graphs showing the relationship between resistivity and temperature (°K).

To illustrate this invention, a production process for $Nd_{2-X}Ce_XCuO_{4-y}$ will be explained by way of example only. $Nd_2O_3$ powder and CuO powder raw materials are mixed and milled by using a ball mill (step 1). Subsequently, the mixed powder is calcined in an Ar(argon) atmosphere at a temperature of 850 to 950°C for 10 to 30 hours (step 2). Then, the calcined product is subjected to pressing (step 3) and to sintering at a temperature of 980 to 1200°C for 10 to 30 hours in an Ar(argon) atmosphere (step 4) so that a sintered target mass of $Nd_2O_3$ and CuO is formed.

After this, while using the mass as a target, sputtering is carried out by using the sputtering device shown in Fig. 2 (step 5).

In the sputtering device, a target 4 and a substrate 5 are provided in a chamber 1, 2 and 3 denoting magnets and 6 and 7 denoting a matching box and rf power source respectively.

Ar gas is supplied into the chamber 1. In the sputtering process MgO or PSZ (partially stabilized zirconia) substrate 5 heated at a temperature of 500 to 700°C is used.

The sputtering is carried out in an Ar(argon) atmosphere of 0.1 torr so that an approximately 5000 Å thick $Nd_2CuO_4$ thin film is deposited on the substrate.

Subsequently, as shown in Figure 3 the substrate 10 obtained is immersed in a Ce-containing solution 11 in a vessel 20.

The vessel is floated on a body 12 of hot water in a constant temperature bath 13. The hot water is heated by a heater 14 connected to a thermocouple 15, and power source 16. As a result of the immersion, $Nd_2CuO_4$ is saturated with Ce (step 6). In the saturation process cerium nitrate ($Ce(NO_3)_3$) was used as dissolved Ce compound in the Ce-containing solution. Ethyl alcohol ($C_2H_5OH$) was used as solvent. In this case 0.4 g of cerium nitrate was added to 100 g of ethyl alcohol. The temperature of the constant temperature bath 13 was kept at 60°C. The Ce saturation procedure was carried out for 15 hours.

In this saturation process, the amount of Ce added to the $Nd_2CuO_4$ thin film can be controlled by controlling the concentration and the temperature of the Ce solution and the time saturation of Ce is allowed to continue for.

Subsequently, the Ce saturated thin film is annealed at a temperature of 900 to 1100°C for 10 to 20 hours in a reducing atmosphere such as nitrogen or argon, etc. (step 7), thereby forming an oxide superconductor thin film of $Nd_{2-X}Ce_XO_{4-y}$ (X = 0.05).

Then, the temperature-resistivity property of the $Nd_{2-X}Ce_XO_{4-y}$ thin film is measured. Typical measurement results are shown in Fig. 4.

As shown in Fig. 4 in the case of a $Nd_{2-X}Ce_XCuO_{4-y}$ superconductor thin film formed by a conventional sputtering process, the zero resistance temperature Tc is 5 to 15K, while on the other hand, the zero resistance temperature Tc of a $Nd_{2-X}Ce_XCuO_{4-y}$ superconductor thin film produced by the inventive process is 40K which is very much higher. Thus the superconductor property was improved.

Next, a production process for $(Bi_{2-X}Pb_XSb_Y)Sr_2Ca_2Cu_3O_{10}$ will be explained by way of example.

A mixed powder of 7 g of $Bi_2O_3$, 17 g of $SrCO_3$, 25 g of $CaCO_3$, 19 g of CuO and 4 g of PbO is milled using a ball mill (step 1). Subsequently, the mixed powder is calcined in air or an oxygen atmosphere at a temperature of 800 to 880°C for 10 to 30 hours (step 2).

Then, the calcined product is subjected to pressing (step 3) and to sintering at a temperature of 830 to 910°C for 10 to 30 hours in air or an oxygen atmosphere (step 4) so that a sintered target mass made of the product obtained is formed.

After this, while using the mass as a target, sputtering is carried out by using the sputtering device shown in Fig. 2 (step 5).

In the sputtering process MgO or PSZ substrate 5 heated to a temperature of 500 to 700°C is used. The sputtering is carried out in an oxygen atmosphere of 0.1 torr so that an approximately 5000 Å thick $(Bi_{2-X}Pb_X)Sr_2Ca_2Cu_3O_{10}$ thin film is deposited on the substrate.

Then, the coated substrate obtained is immersed in a Sb-containing solution to saturate the coating with Sb as shown in Fig. 3. As a solution for this purpose, SbOCl (antimonyl chloride) obtained by adding antimony chloride to water and hydrolyzing it is used. For this purpose 100 g of water added to 95 g (0.4 mol) of $SbCl_3$ may be used. The temperature of the constant temperature bath was kept at 50° C. The Sb saturation procedure was carried out for 10 hours.

Subsequently, the Sb saturated thin film obtained is annealed at a temperature of 820 to 1100° C for 10 to 30 hours in an oxygen atmosphere (step 7) to form an oxide superconductor thin film of $Bi_{2-X-Y}Pb_XSb_Y)Sr_2Ca_2Cu_3O_{10}$ (Y = 0.1).

Finally, the temperature-resistivity property of the $(Bi_{2-X-Y}Pb_XSb_Y)Sr_2Ca_2Cu_3O_{10}$ is measured. The measurement results are as shown in Fig. 5. As shown in Fig. 5, a zero resistance temperature Tc of about 115K is obtained which is higher than that obtained with products produced by conventional procedures.

Thus, in summary, there is now provided a method for producing an oxide superconductor comprising the steps of forming on a substrate a layer of elements which is deficient in respect of one element for producing an oxide superconductor from said elements and immersing said substrate with layer formed thereon in a solution containing at leat one supplementary element required for producing said oxide superconductor.

## Claims

1. A method for producing an oxide superconductor comprising the steps of:
forming on a substrate a layer of (n-m) elements wherein n represents the number of elements which is to form an oxide superconductor and m is an integer less than n such that m ≧ 1; and
immersing the substrate with said layer thereon in a solution containing a supplementary element which is a said oxide superconductor composing element not present in said layer.

2. A method for producing an oxide superconductor comprising the steps of:
forming a layer of oxide superconductor-forming elements on a substrate and
immersing said substrate with said layer formed thereon in a solution containing a supplementary element which is at least one of elements composing said oxide superconductor.

3. A method according to claim 1 or 2, wherein formation of said layer comprises a sputtering method.

4. A method according to any preceding claim, wherein said layer comprises an A-Cu-O type compound wherein A is a lanthanoid element.

5. A method according to any preceding claim, wherein said supplementary element is not a skeletal element in said oxide superconductor.

6. A method according to claim 5, wherein said supplementary element is Ce.

7. A method according to claim 4, 5 or 6, wherein said A-Cu-O type compound is $Nd_2CuO_{4-Y}$.

8. A method according to claims 4, 5 and 8, wherein said $Nd_2CuO_{4-Y}$ layer is saturated with a Ce containing solution so that a $Nd_{2-X}CuO4_{-Y}$ compound is formed.

9. A method according to claim 6 or 8, wherein a solution of $Ce(NO_3)_3$, $Ce(CH_3COO)_3$, $Ce_2(CO_3)_3$ or $Ce_2(C_2O_4)_3$ is used as Ce-containing solution.

10. A method according to claim 8 or 9, wherein said $Nd_2Cuo_{4-Y}$ layer is formed by a sputtering process in a reducing atmosphere.

11. A method according to claim 1 or 2, wherein said layer essentially consists of $(Bi_{2-X}Pb_X)Sr_2Ca_2Cu_3O_{10}$

12. A method according to claim 1, 2 or 11, wherein said supplementary element is Sb.

13. A method according to claim 12, wherein said $(Bi_{2-X}Pb_X)Sr_2Ca_2Cu_3O_{10}$ layer is saturated with a Sb containing solution so that a $(Bi_{2-X-Y}Pb_XSb_Y)Sr_2Ca_2Cu_3O_{10}$. compound is formed.

14. A method according to claim 13, wherein said Sb containing solution is a $SbCl_3$, SbOCl or $H_3SbCl_6$-containing solution.

15. A method according to any preceding claim. wherein after said immersing step, annealing of the substrate having said layer thereon is carried out.

16. A method according to any one of 4 to 10 and 15, wherein annealing is carried out in a reducing atmosphere.

17. A method according to any one of claims 11 to 14 and 15, wherein annealing is carried out in an oxidising atmosphere.

Fig. 1

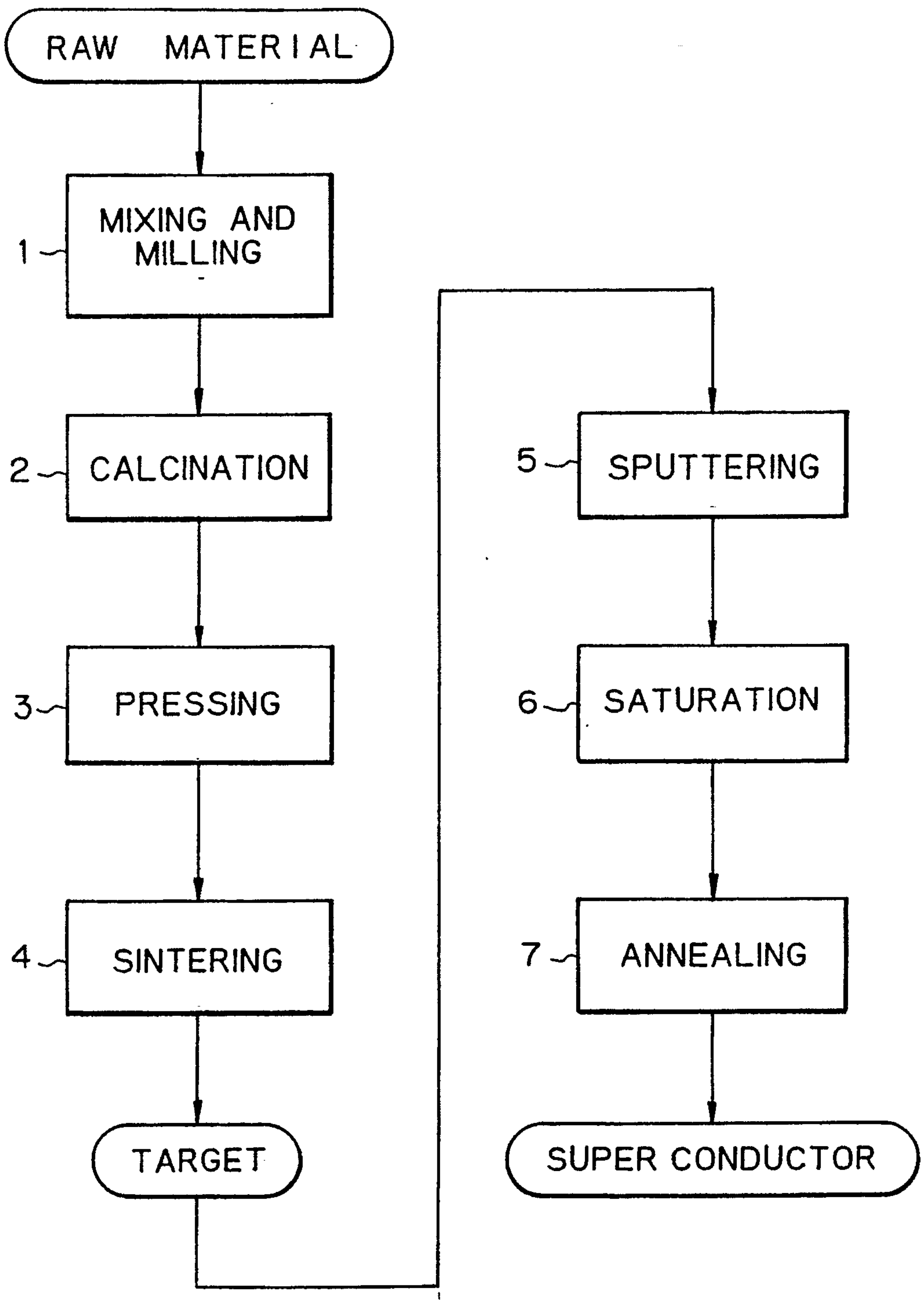
RAW MATERIAL
1 MIXING AND MILLING
2 CALCINATION
3 PRESSING
4 SINTERING
TARGET
5 SPUTTERING
6 SATURATION
7 ANNEALING
SUPER CONDUCTOR

*Fig. 2*

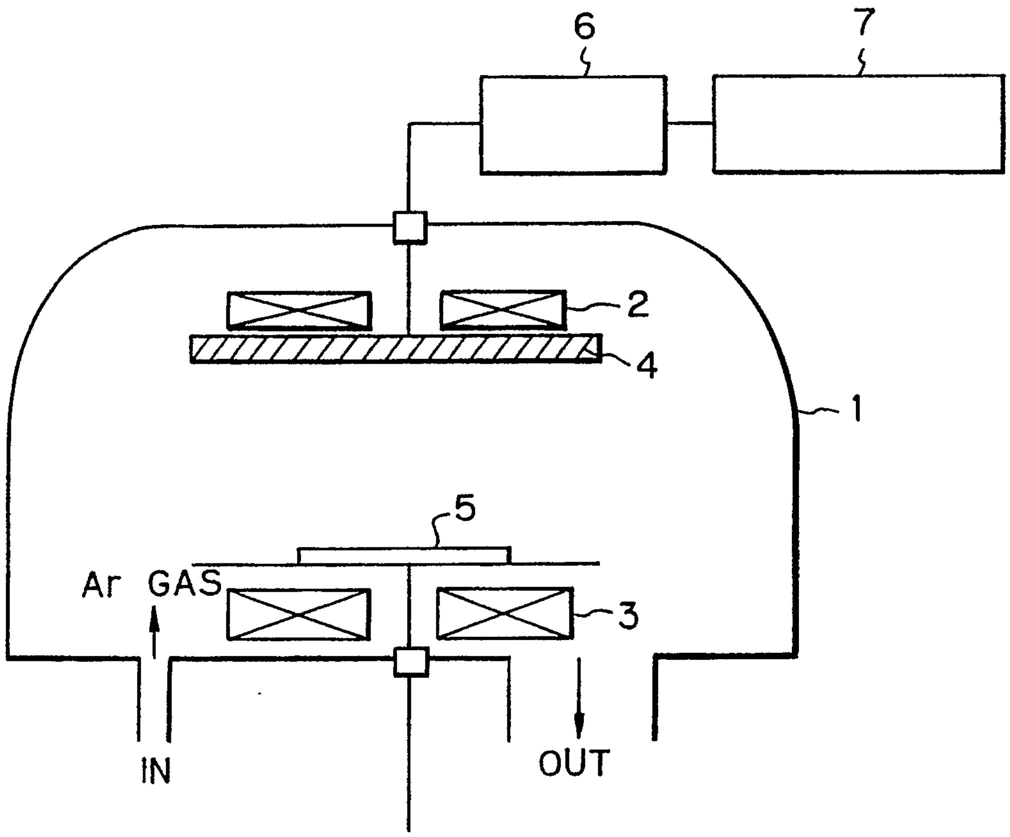


*Fig. 3*

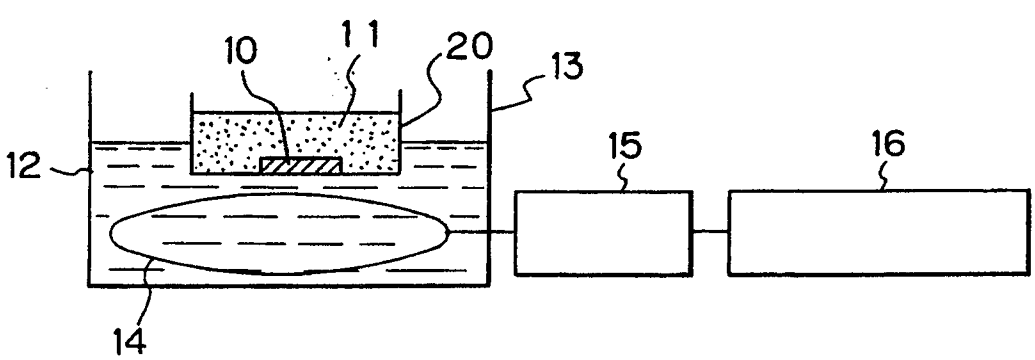

*Fig. 4*

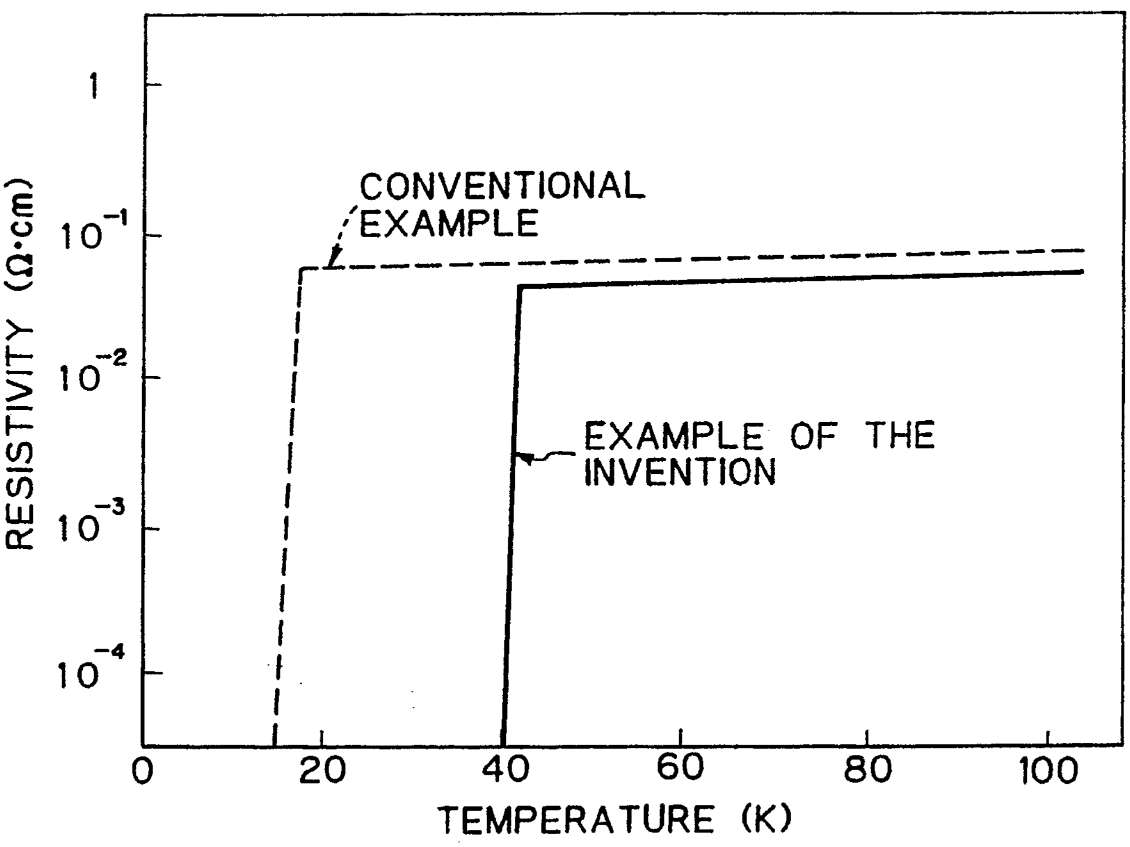
1
$10^{-1}$
$10^{-2}$
$10^{-3}$
$10^{-4}$
RESISTIVITY (Ω·cm)
CONVENTIONAL EXAMPLE
EXAMPLE OF THE INVENTION
0
20
40
60
80
100
TEMPERATURE (K)

*Fig. 5*

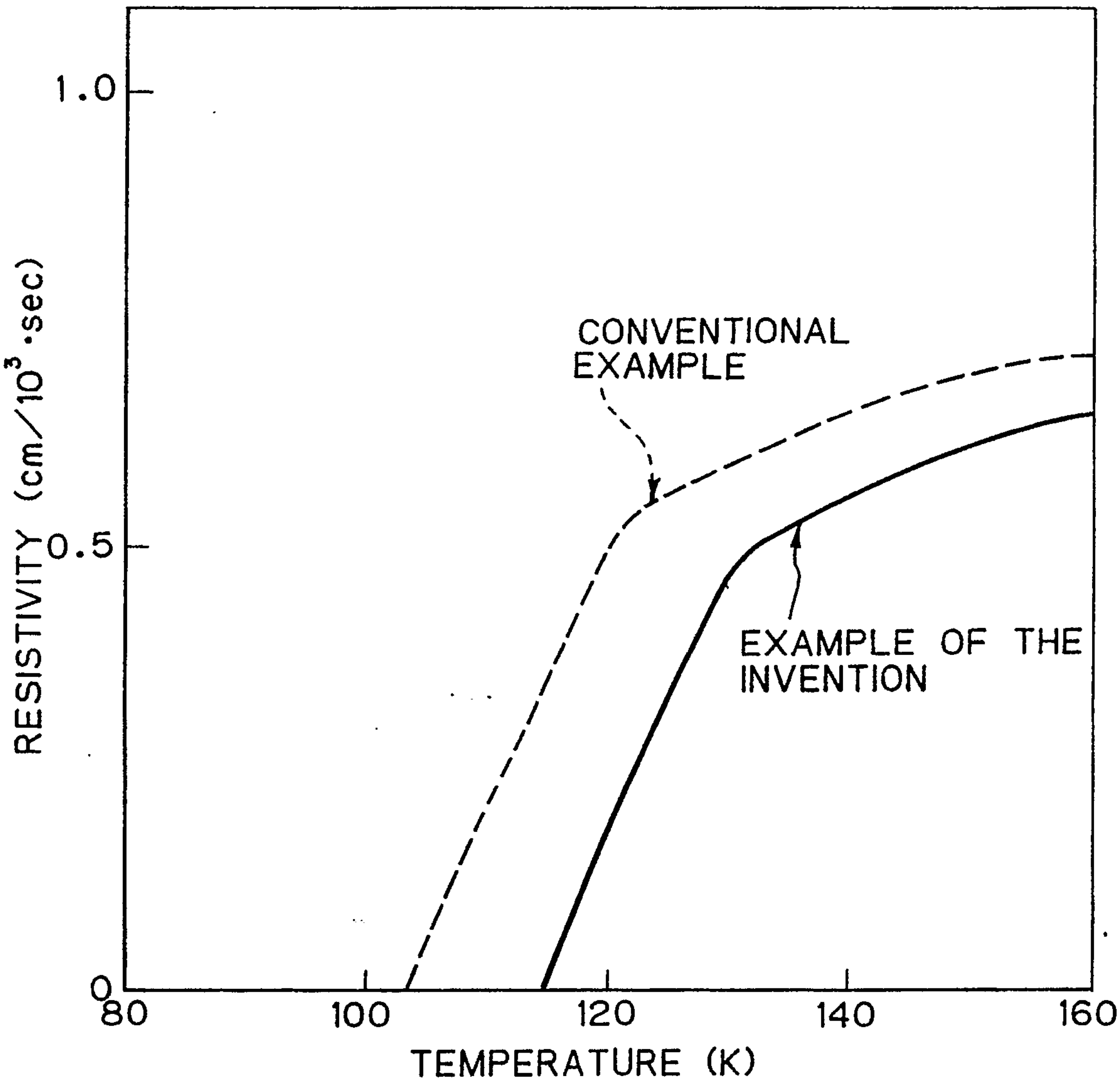

1.0
0.5
0
RESISTIVITY (cm/$10^3$·sec)
CONVENTIONAL EXAMPLE
EXAMPLE OF THE INVENTION
80
100
120
140
160
TEMPERATURE (K)